# EUROPÄISCHE PATENTANMELDUNG

(11) **EP 2 511 987 A2**
(43) Veröffentlichungstag der Anmeldung: **17.10.2012**
(21) Anmeldenummer: 12159305.7
(22) Anmeldetag: 13.03.2012
(51) Int. Cl.: H01R 12/72, H01R 13/26

(54) **Verbesserte Mehrfach-Direktkontaktierung von elektrischen Bauteilen**

(30) Priorität: 15.04.2011 DE 102011007481
(71) Anmelder: Robert Bosch GmbH, 70442 Stuttgart (DE)
(72) Erfinder: Schoenfeld, Michael, 70771 Leinfelden-Echterdingen (DE)

(57) **Zusammenfassung**

Die Erfindung betrifft eine elektrische Anordnung, umfassend eine Trägerplatte (2) mit wenigstens einer an einer Flachseite der Trägerplatte (2) angeordneten Stufe (20; 21), wobei die Stufe an der Trägerplatte eine erste Fläche (22; 24) und eine zweite Fläche (23; 25) definiert, wobei an der ersten Fläche (22; 24) wenigstens ein erster Kontaktbereich (51; 53) und an der zweiten Fläche (23; 25) ein zweiter Kontaktbereich (52; 54) angeordnet ist, und ein Direktsteckelement (3) mit wenigstens einem ersten Direktkontakt (31) und einem zweiten Direktkontakt (32), wobei der erste Direktkontakt (31) mit dem ersten Kontaktbereich (51) und der zweite Direktkontakt (32) mit dem zweiten Kontaktbereich (52) in Kontakt bringbar ist, und wobei die ersten und zweiten Direktkontakte (51, 52) eine gleiche Kontaktrichtung (K1) aufweisen.

## Beschreibung

### Stand der Technik

Die vorliegende Erfindung betrifft eine verbesserte Mehrfach-Direktkontaktierung von elektrischen Bauteilen, wie z.B. Leiterplatten, sowie eine Trägerplatte mit verbesserten Direkt-Kontaktmöglichkeiten und ein verbessertes Direktsteckelement.

In jüngster Zeit werden vermehrt Direktsteckkontakte verwendet, bei denen ein Direktsteckelement unmittelbar auf eine Leiterplatte gesteckt wird. Bei einer Vielzahl von Kontaktbereichen an der Leiterplatte werden die Kontaktbereiche dabei in einer Reihe nahe einer Leiterplattenkante angeordnet. Wenn hierbei viele Kontaktbereiche notwendig sind, ergibt sich eine entsprechende Länge an der Leiterplatte sowie eine komplizierte Verdrahtung auf der Leiterplatte, da dadurch die Wege zwischen den Kontaktbereichen und Bauelementen auf der Leiterplatte mit der Anzahl der Kontaktbereiche jeweils vergrößert werden müssen. Um die Anzahl der Kontakte zu erhöhen, könnte man Kontaktbereiche sowohl an einer Oberseite als auch an einer Unterseite der Leiterplatte vorsehen. Je nach Anzahl der notwendigen Kontaktbereiche an der Leiterplatte ergeben sich dabei jedoch immer noch relativ lange Kontaktreihen. Es ist jedoch wünschenswert, insbesondere bei Massenprodukten, wie beispielsweise Steuergeräten für Fahrzeuge, bei denen eine Vielzahl von gleichen Steuergeräten benötigt werden, eine möglichst wirtschaftliche Herstellung der Kontaktierung zu ermöglichen.

### Offenbarung der Erfindung

Die erfindungsgemäße elektrische Anordnung mit den Merkmalen des Anspruchs 1 umfasst eine Trägerplatte, wie beispielsweise eine Leiterplatte, und ein Direktsteckelement. Dabei weist die erfindungsgemäße Anordnung den Vorteil auf, dass eine Vielzahl von Kontaktbereichen an der Leiterplatte vorgesehen sein kann, welche mittels des Direktsteckelements direkt kontaktiert werden können. Hierbei kann ein sehr einfacher und wirtschaftlich herzustellender Direktsteckkontakt realisiert werden. Dies wird erfindungsgemäß dadurch erreicht, dass die Trägerplatte an einer Flachseite wenigstens eine Stufe aufweist, welche zwei Flächen an der Trägerplatte definiert, an denen Kontaktbereiche angeordnet werden können. Hierdurch ist es möglich, Kontaktbereiche in mehreren Ebenen an einer Seite der Trägerplatte anzuordnen und somit eine Direktkontaktierung an der Trägerplatte auf wenigstens zwei Ebenen auszuführen.

Die Unteransprüche zeigen bevorzugte Weiterbildungen der Erfindung.

Besonders bevorzugt sind alle Direktkontakte am Direktsteckelement baugleich. Hierdurch kann ein besonders einfacher Aufbau des Direktsteckelements realisiert werden und eine große Kosteneinsparung ermöglicht werden.

Besonders bevorzugt sind die Direktkontakte des Direktsteckelements in einer Längsrichtung des Direktsteckelements versetzt angeordnet. Hierdurch resultiert ein sehr kompaktes Direktsteckelement.

Weiter bevorzugt sind die ersten und zweiten Direktkontakte am Direktsteckelement wenigstens in einer ersten und zweiten Ebene, vorzugsweise in drei oder vier Ebenen, angeordnet.

Vorzugsweise ist die Trägerplatte ein einstückiges Bauteil. Weiter bevorzugt ist eine Dicke der Trägerplatte an der Stufe reduziert, insbesondere ist die Dicke auf weniger als die Hälfte einer normalen Dicke der Trägerplatte reduziert. Hierdurch kann ein besonders kompakter Aufbau realisiert werden.

Besonders bevorzugt sind die Direktkontakte am Direktsteckelement als Federkontakte mit einer Federzunge ausgebildet. Hierdurch sind die Direktkontakte sehr einfach und kostengünstig herstellbar. Die Direktkontakte können dann mit bekannten Verfahren, z.B. Crimpen, mit Kabeln usw. verbunden werden.

Weiter bevorzugt umfasst die elektrische Anordnung ein Moldgehäuse, wobei die Trägerplatte derart im Moldgehäuse angeordnet ist, dass die Stufe außerhalb des Moldgehäuses liegt. Hierdurch kann das Moldgehäuse beispielsweise als Anschlag für ein Gehäuse des Direktsteckelements dienen.

Um eine möglichst große Anzahl von Kontaktbereichen an der Trägerplatte anordnen zu können, ist vorzugsweise an einer Oberseite eine erste Stufe und an einer Unterseite eine zweite Stufe angeordnet, wodurch insgesamt vier Flächen an der Trägerplatte definiert werden, an denen Kontaktbereiche angeordnet werden können. Hierdurch kann eine sehr große Anzahl von Kontaktbereichen an der Trägerplatte angeordnet werden. Vorzugsweise werden die Kontaktbereiche an wenigstens drei Flächen oder an allen Flächen vorgesehen. Es sei angemerkt, dass es auch möglich ist, dass selbstverständlich an der Oberseite und/oder Unterseite zusätzlich weitere Stufen vorgesehen werden können, welche entsprechend weitere Flächen zur Anordnung von Kontaktbereichen an der Trägerplatte definieren.

Die Trägerplatte ist vorzugsweise eine Leiterplatte oder ein Substrat oder ein Stanzgitter. Die Kontaktbereiche an der Trägerplatte können dabei vorzugsweise als Lands oder Pads ausgebildet sein.

Weiterhin betrifft die vorliegende Erfindung eine Trägerplatte, insbesondere eine Leiterplatte, mit wenigstens einer an einer Flachseite der Trägerplatte angeordneten Stufe. Die abgestufte Trägerplatte definiert somit eine erste und eine zweite Fläche, an welchen erste und zweite Kontaktbereiche angeordnet sind. Hierdurch ist ein mehrreihiger Direktkontakt an der Trägerplatte in verschiedenen Ebenen möglich. Besonders bevorzugt ist an einer Oberseite der Trägerplatte eine erste Stufe und an einer Unterseite der Trägerplatte eine zweite Stufe vorgesehen. Weiter bevorzugt weist die Trägerplatte an der Oberseite und/oder Unterseite mehrere Stufen auf.

Weiterhin betrifft die vorliegende Erfindung ein Direktsteckelement mit einem ersten und einem zweiten Direktkontakt, wobei die ersten und zweiten Direktkontakte in einer Längsrichtung des Direktsteckelements um einen vorbestimmten Abstand versetzt sind und wobei die ersten und zweiten Direktkontakte am Direktsteckelement wenigstens in einer ersten und einer zweiten Ebene angeordnet sind. Die ersten und zweiten Direktkontakte sind dabei in der gleichen Kontaktrichtung ausgerichtet, so dass eine Kontaktierung an einer Seite einer Trägerplatte auf zwei verschiedenen Ebenen möglich ist. Besonders bevorzugt sind die Direktkontakte baugleich, wodurch große Kosteneinsparungen bei der Herstellung erreichbar sind.

Weiterhin betrifft die vorliegende Erfindung ein Steuergerät für ein Kraftfahrzeug, welches eine erfindungsgemäße elektrische Anordnung oder eine erfindungsgemäße Trägerplatte oder ein erfindungsgemäßes Direktsteckelement umfasst.

### Zeichnung

Nachfolgend wird ein bevorzugtes Ausführungsbeispiel der Erfindung unter Bezugnahme auf die begleitende Zeichnung im Detail beschrieben. In der Zeichnung ist:
- Figur 1: eine schematische Schnittansicht einer elektrischen Anordnung gemäß einem Ausführungsbeispiel der Erfindung, und
- Figur 2: eine schematische Draufsicht auf einen freiliegenden Teil einer Trägerplatte der Anordnung von Figur 1.

### Bevorzugte Ausführungsform der Erfindung

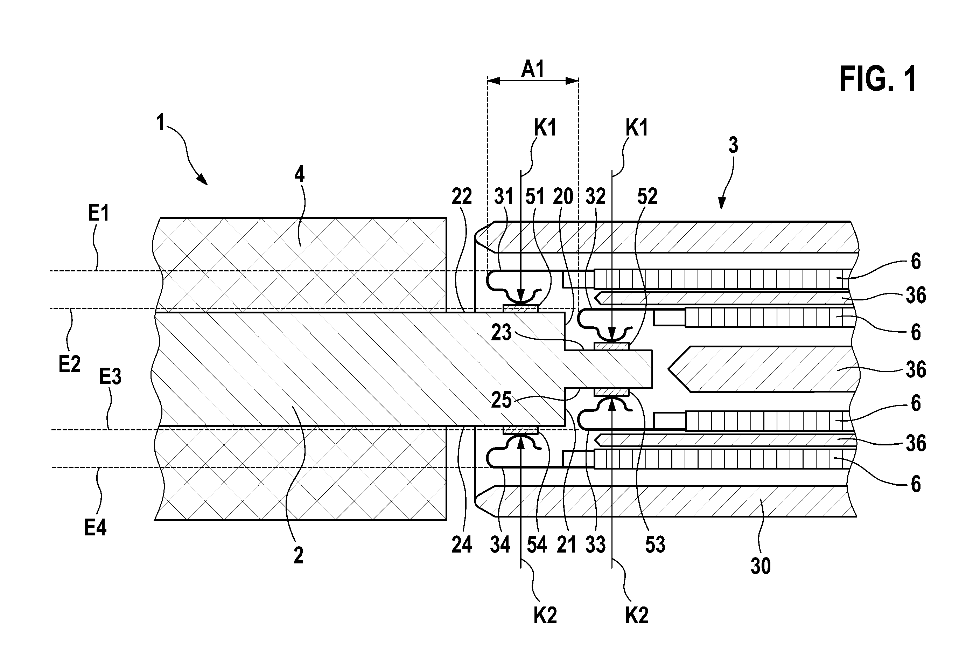

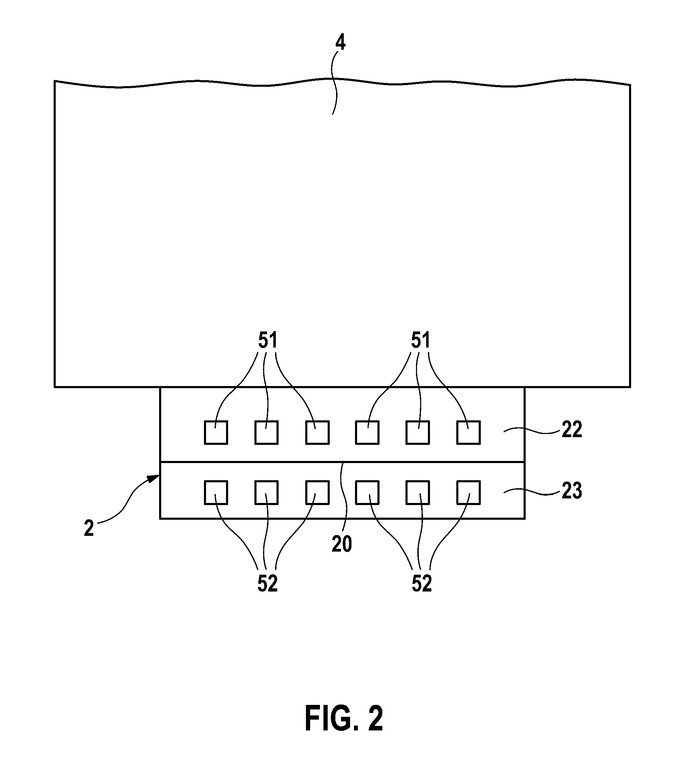

Nachfolgend wird unter Bezugnahme auf die Figuren 1 und 2 eine elektrische Anordnung 1 gemäß einem bevorzugten Ausführungsbeispiel der Erfindung im Detail beschrieben.

Wie insbesondere aus Figur 1 ersichtlich ist, umfasst die elektrische Anordnung 1 eine Trägerplatte 2, welche in diesem Ausführungsbeispiel eine Leiterplatte ist, und ein Direktsteckelement 3. Die Trägerplatte 2 ist teilweise von einem Moldgehäuse 4 umgeben und die Trägerplatte 2 ist ferner derart ausgebildet, dass an dem vom Moldgehäuse 4 freiliegenden Teilbereich an einer Oberseite eine erste Stufe 20 und an einer Unterseite eine zweite Stufe 21 ausgebildet ist. Hierdurch werden an der Oberseite der Trägerplatte 2 eine erste Fläche 22 und eine zweite Fläche 23 definiert, welche als zueinander parallele Ebenen vorgesehen sind. An der Unterseite der Trägerplatte 2 wird eine dritte Fläche 24 und eine vierte Fläche 25 definiert, welche ebenfalls als zueinander parallele Ebenen vorgesehen sind. An allen vier Flächen 22, 23, 24 und 25 sind jeweils eine Vielzahl von Kontaktbereichen 51, 52, 53, 54 angeordnet. Die Kontaktbereiche sind dabei auf jeder der Flächen in einer Reihe, d.h., auf einer Linie, angeordnet (vgl. Figur 2). Die Kontaktbereiche sind als Lands auf der Leiterplatte vorgesehen. Die Trägerplatte 2 ist ein einstückiges Bauteil, wobei die Stufen 20, 21 eine reduzierte Dicke der Trägerplatte, vorzugsweise auf eine Hälfte der Basisdicke, bereitstellen.

Das Direktsteckelement 3 umfasst, wie aus Figur 1 ersichtlich ist, ein Gehäuse 30, sowie erste Direktkontakte 31, zweite Direktkontakte 32, dritte Direktkontakte 33 und vierte Direktkontakte 34. Wie aus Figur 1 ersichtlich ist, sind die Direktkontakte 31, 32, 33, 34 jeweils in vier Ebenen E1, E2, E3, E4 angeordnet. Dabei sind die Direktkontakte jeweils über ein Kabel 6 elektrisch angeschlossen. Wie aus Figur 1 gezeigt, verlaufen die Vielzahl der Kabel 6 jeweils in separaten, durch Gehäusewände 36 unterteilten Bereichen. Die Direktkontakte 31, 32, 33, 34 sind dabei jeweils baugleich. Hierdurch ergeben sich große herstellungsbedingte Vorteile. Die Direktkontakte 31, 32, 33, 34 sind dabei als Federzungen ausgebildet und können mittels bekannter Verfahren an den Kabeln 6 befestigt werden.

Wie weiter aus Figur 1 ersichtlich ist, ist der erste Direktkontakt 31 um einen Abstand A1 in Längsrichtung des Direktsteckelements 3 vom zweiten Direktkontakt 32 beabstandet. In gleicher Weise ist der vierte Direktkontakt 34 vom dritten Direktkontakt 33 in Längsrichtung des Direktsteckelements 3 um den Abstand A1 beabstandet.

Wie aus Figur 1 ersichtlich ist, stehen dabei die ersten Direktkontakte 31 mit den Kontaktbereichen 51 der ersten Fläche 22 in Kontakt. Die zweiten Direktkontakte 32 stehen mit den Kontakten 52 der zweiten Fläche 23 in Kontakt. Die dritten Direktkontakte 33 stehen mit den Kontaktbereichen 53 der dritten Fläche 24 in Kontakt und die vierten Direktkontakte 34 stehen mit den Kontaktbereichen 54 der vierten Fläche 25 in Kontakt. Dabei sind die ersten und zweiten Direktkontakte am Direktsteckelement 3 in die gleiche erste Kontaktrichtung K1 ausgerichtet. Die dritten und vierten Direktkontakte sind in der zur ersten Kontaktrichtung K1 entgegengesetzten Kontaktrichtung K2 ausgerichtet.

Somit ist es erfindungsgemäß möglich, dass baugleiche Direktkontakte 31, 32, 33, 34 verwendet werden, welche in verschiedenen Ebenen im Direktsteckelement 3 angeordnet sind und Kontaktbereiche 51, 52, 53, 54 an einer abgestuften Trägerplatte 2 kontaktieren. Dadurch kann eine auf verschiedenen Ebenen vorgesehene, mehrreihige Direktkontaktierung ermöglicht werden. Hierbei kann insbesondere eine sehr kostengünstige Herstellung des Direktkontakts realisiert werden. Die Erfindung wird vorzugsweise in Steuergeräten von Fahrzeugen, beispielsweise Getriebesteuergeräten oder Motorsteuergeräten, verwendet.

## Patentansprüche

1. Elektrische Anordnung, umfassend
- eine Trägerplatte (2) mit wenigstens einer an einer Flachseite der Trägerplatte (2) angeordneten Stufe (20; 21), wobei die Stufe an der Trägerplatte eine erste Fläche (22; 24) und eine zweite Fläche (23; 25) definiert, wobei an der ersten Fläche (22; 24) wenigstens ein erster Kontaktbereich (51; 53) und an der zweiten Fläche (23; 25) ein zweiter Kontaktbereich (52; 54) angeordnet ist, und
- ein Direktsteckelement (3) mit wenigstens einem ersten Direktkontakt (31) und einem zweiten Direktkontakt (32),
- wobei der erste Direktkontakt (31) mit dem ersten Kontaktbereich (51) und der zweite Direktkontakt (32) mit dem zweiten Kontaktbereich (52) in Kontakt bringbar ist, und
- wobei die ersten und zweiten Direktkontakte (51, 52) eine gleiche Kontaktrichtung (K1) aufweisen.

2. Anordnung nach Anspruch 1, **dadurch gekennzeichnet, dass** die Direktkontakte (31, 32, 33, 34) alle baugleich sind.

3. Anordnung nach einem der vorhergehenden Ansprüche, **dadurch gekennzeichnet, dass** der erste und zweite Direktkontakt (31, 32) in einer Längsrichtung des Direktsteckelements (3) um einen Abstand (A1) versetzt sind.

4. Anordnung nach einem der vorhergehenden Ansprüche, **dadurch gekennzeichnet, dass** der erste Direktkontakt (31) in einer ersten Ebene (E1) angeordnet ist und der zweite Direktkontakt (32) in einer zweiten Ebene (E2) angeordnet ist, wobei die Ebenen (E1, E2) zueinander parallel sind.

5. Anordnung nach einem der vorhergehenden Ansprüche, **dadurch gekennzeichnet, dass** die Trägerplatte (2) ein einstückiges Bauteil ist und insbesondere eine Dicke der Trägerplatte an der Stufe (20, 21) reduziert ist.

6. Anordnung nach einem der vorhergehenden Ansprüche, ferner umfassend ein Moldgehäuse (4), wobei die Trägerplatte (2) teilweise vom Moldgehäuse (4) umschlossen ist, derart, dass die Stufe (20; 21) an der Trägerplatte außerhalb des Moldgehäuses (4) liegt.

7. Anordnung nach einem der vorhergehenden Ansprüche, **dadurch gekennzeichnet, dass** die Trägerplatte (2) an einer Oberseite die erste Stufe (20), welches die erste und zweite Fläche (22, 23) definiert, und an einer Unterseite eine zweite Stufe (21) umfasst, wobei die zweite Stufe (21) eine dritte Fläche (24) und eine vierte Fläche (25) definiert, wobei Kontaktbereiche (51, 52, 53, 54) an wenigstens drei Flächen oder an allen Flächen (22, 23, 24, 25) vorgesehen sind.

8. Trägerplatte (2), insbesondere Leiterplatte, umfassend wenigstens eine an einer Flachseite der Trägerplatte (2) angeordnete erste Stufe (20), welche eine erste Fläche (22) und eine zweite Fläche (23) definiert, wobei die erste Fläche (22) wenigstens einen ersten Kontaktbereich (51) aufweist und wobei die zweite Fläche (23) wenigstens einen zweiten Kontaktbereich (52) aufweist.

9. Direktsteckelement (3) mit wenigstens einem ersten Direktkontakt (31) und wenigstens einem zweiten Direktkontakt (32), wobei die ersten und zweiten Direktkontakte (31, 32) eine gleiche Kontaktrichtung (K1) aufweisen,
- wobei die ersten und zweiten Direktkontakte (31, 32) in einer Längsrichtung des Direktsteckelements (3) um einen Abstand (A1) versetzt angeordnet sind, und
- wobei die ersten und zweiten Direktkontakte (31, 32) am Direktsteckelement (3) wenigstens in einer ersten Ebene (E1) und einer zweiten Ebene (E2) angeordnet sind.

10. Steuergerät, umfassend eine Anordnung nach einem der Ansprüche 1 bis 7 oder eine Trägerplatte nach Anspruch 8 oder ein Direktsteckelement nach Anspruch 9.
